# EUROPÄISCHE PATENTANMELDUNG

(11) **EP 3 089 565 A1**
(43) Veröffentlichungstag der Anmeldung: **02.11.2016**
(21) Anmeldenummer: 16162575.1
(22) Anmeldetag: 29.03.2016
(51) Int. Cl.: H05K 1/02

(54) **LEITERPLATTE**

(30) Priorität: 29.04.2015 AT 503472015
(71) Anmelder: MELECS EWS GmbH & Co KG, 7011 Siegendorf (AT)
(72) Erfinder: Koch, Armin, 6807 Feldkirch (AT); Neumann, Gerhard, 3231 St. Margarethen (AT); Hellinger, Leopold, 3710 Ziersdorf (AT)
(74) Vertreter: Maier, Daniel Oliver

(57) **Zusammenfassung**

Gezeigt wird eine Leiterplatte mit zwei metallischen Außenschichten (1, 2) und mindestens einer, insbesondere metallischen, Zwischenschicht (3),
- wobei im Falle einer metallischen Zwischenschicht zwischen den Außenschichten (1, 2) und der Zwischenschicht (3) Isolierschichten (4) angeordnet sind,
- wobei auf mindestens einer der Außenflächen der Leiterplatte mindestens eine Kontaktfläche für ein zu kühlendes Bauelement (9) angeordnet ist,
- wobei auf der gegenüber liegenden Außenfläche der Leiterplatte mindestens ein Kühlelement (11) angeordnet ist, und
- wobei die Kontaktfläche für das zu kühlende Bauelement (9) mittels eines Plättchens (5) aus isoliertem Metallsubstrat elektrisch vom Kühlelement (11) isoliert ist. Dabei ist vorgesehen, dass die Kontaktfläche für das zu kühlende Bauelement (9) durch eine oder mehrere metallische Durchkontaktierungen (13) mit der gegenüber liegenden Außenfläche der Leiterplatte verbunden ist, wo das Plättchen (5) aus isoliertem Metallsubstrat außen an der Außenfläche der Leiterplatte angebracht und mit dem Kühlelement (11) in Kontakt ist.

## Beschreibung

### Technisches Gebiet

Die Erfindung betrifft eine Leiterplatte mit zwei metallischen Außenschichten und mindestens einer, insbesondere metallischen, Zwischenschicht,
- wobei im Falle einer metallischen Zwischenschicht zwischen den Außenschichten und der Zwischenschicht Isolierschichten angeordnet sind,
- wobei auf mindestens einer der Außenflächen der Leiterplatte mindestens eine Kontaktfläche für ein zu kühlendes Bauelement angeordnet ist,
- wobei auf der gegenüber liegenden Außenfläche der Leiterplatte mindestens ein Kühlelement angeordnet ist, und
- wobei die Kontaktfläche für das zu kühlende Bauelement mittels eines Plättchens aus isoliertem Metallsubstrat elektrisch vom Kühlelement isoliert ist. Die Erfindung umfasst auch ein Verfahren zur Herstellung einer entsprechenden Leiterplatte, wobei als Ausgangsmaterial eine Standard-Leiterplatte (wie eine FR-4 Mehrlagen-Leiterplatte) verwendet werden kann.

Eine Leiterplatte (Platine oder gedruckte Schaltung; englisch printed circuit board, PCB) ist ein Träger für elektronische Bauteile. Sie dient der mechanischen Befestigung und elektrischen Verbindung. Leiterplatten bestehen aus elektrisch isolierendem Material mit daran haftenden, leitenden Verbindungen (Leiterbahnen). Als isolierendes Material ist faserverstärkter Kunststoff üblich, die Leiterplatte könnte aber auch aus Keramik gefertigt sein oder eine oder mehrere Keramik- oder Metallschichten enthalten. Die Leiterbahnen werden aus einer dünnen leitenden Schicht (zumeist Kupfer) geätzt. Die Schichtstärke beträgt typischerweise 35 µm und für Anwendungen mit höheren Strömen zwischen 70 µm und 140 µm. Um dünnere Leiterbahnen zu ermöglichen, werden auch Leiterplatten mit nur 18 µm leitender Schicht hergestellt. Die Bauelemente werden auf Lötflächen (Lötpads, Kontaktflächen) oder in Lötaugen gelötet, die ebenfalls aus der dünnen leitenden Schicht geätzt werden. Durch das Anlöten werden die Bauelemente mit der Leiterplatte verbunden, also gleichzeitig an der Leiterplatte mechanisch befestigt und elektrisch kontaktiert.

Die Abmessungen von Leiterplatten sind genormt, die üblichen Dicken der Leiterplatten liegen zwischen 1 und 3 mm.

### Stand der Technik

Für Leiterplatten mit hohen Anforderungen an die Wärmeabführung werden Basismaterialien mit Metallkernen wie Aluminium oder Kupfer verwendet, z.B. im Bereich der Beleuchtungstechnik mit Hochleistungsleuchtdioden. Diese Trägermaterialien werden auch als Direct Bonded Copper oder als isoliertes Metallsubstrat (Insulated metal substrate - IMS) bezeichnet.

Zusätzlich können unter Bauteilen mit hoher Wärmeentwicklung auch innerhalb der Leiterplatte Plättchen aus isoliertem Metallsubstrat eingebracht werden, bei denen die Isolierschichten beispielsweise über besonders gute Temperaturbeständigkeit verfügen, also etwa eine höhere Temperaturbeständigkeit als die Isolierschichten der Leiterplatte aufweisen. Die Schichten des Plättchens sind dabei parallel zur Ebene der Leiterplatte bzw. zu den Schichten der Leiterplatte angeordnet und werden von den metallischen Außenschichten der Leiterplatte in der Leiterplatte eingeschlossen.

Nachteilig an dieser Anordnung des Plättchens ist, dass dafür die Leiterplatte vorerst ohne die metallischen Außenschichten und die daran angrenzenden Isolierschichten hergestellt werden muss, dann wird in die Leiterplatte eine durchgehende Ausnehmung gefräst, das Plättchen eingesetzt und anschließend werden Isolierschichten und die beiden metallischen Außenschichten der Leiterplatte aufgebracht.

### Darstellung der Erfindung

Es ist daher eine Aufgabe der vorliegenden Erfindung, eine Leiterplatte zur Verfügung zu stellen, welche an den Stellen, die für Bauteile mit hoher Wärmeentwicklung vorgesehen sind, Isolierschichten mit besonders guter Temperaturbeständigkeit verfügt, jedoch einfacher herzustellen ist.

Diese Aufgabe wird durch eine Leiterplatte mit den Merkmalen des Patentanspruchs 1 gelöst. Vorteilhafte Ausgestaltungen der Erfindung sind in den jeweiligen abhängigen Ansprüchen definiert.

Anspruch 1 bezieht sich auf eine eingangs erwähnte Leiterplatte mit zwei metallischen Außenschichten und mindestens einer, insbesondere metallischen, Zwischenschicht,
- wobei im Falle einer metallischen Zwischenschicht zwischen den Außenschichten und der Zwischenschicht Isolierschichten angeordnet sind,
- wobei auf mindestens einer der Außenflächen der Leiterplatte mindestens eine Kontaktfläche für ein zu kühlendes Bauelement angeordnet ist,
- wobei auf der gegenüber liegenden Außenfläche der Leiterplatte mindestens ein Kühlelement angeordnet ist, und
- wobei die Kontaktfläche für das zu kühlende Bauelement mittels eines Plättchens aus isoliertem Metallsubstrat elektrisch vom Kühlelement isoliert ist. Weist die Leiterplatte mehrere metallische Zwischenschichten auf, so ist auch zwischen diesen Zwischenschichten jeweils eine Isolierschicht vorhanden. Wenn keine metallischen Zwischenschichten vorhanden sind, muss es jedenfalls mindestens eine Isolierschicht als Zwischenschicht geben, welche die beiden metallischen Außenschichten voneinander trennt.

Erfindungsgemäß ist vorgesehen, dass die Kontaktfläche für das zu kühlende Bauelement durch eine oder mehrere metallische Durchkontaktierungen mit der gegenüber liegenden Außenfläche der Leiterplatte verbunden ist, wo das Plättchen aus isoliertem Metallsubstrat außen an der Außenfläche der Leiterplatte angebracht und mit dem Kühlelement in Kontakt ist.

Dadurch, dass das Plättchen aus isoliertem Metallsubstrat nun nicht mehr im Inneren der Leiterplatte angeordnet ist, kann eine Standard-Leiterplatte mit metallischen Außenschichten verwendet werden. Es entfallen daher im Vergleich zu früheren Leiterplatten das Ausfräsen der inneren Schichten der Leiterplatte und das folgende Aufbringen der metallischen Außenschichten der Leiterplatte.

Das Anbringen von Durchkontaktierungen, den sogenannten Thermal Vias, in Leiterplatten ist dagegen einfach möglich und stellt einen Standardvorgang bei der Leiterplattenfertigung dar. Die primäre Aufgabe der Durchkontaktierungen, die meist normal, insbesondere gerade, zur Ebene der Leiterplatte verlaufen, besteht in einer Verbesserung der Wärmeleitfähigkeit; sie nutzen den hohen Wärmeleitwert von Kupfer, dem gängigsten Material der Durchkontaktierung. Durch eine dichte Anordnung von solchen Durchkontaktierungen, beispielsweise in einem Raster von 0,5 mm und einem Durchmesser von 0,25 mm, können effektiv bis zu 10 % Kupfer in die Leiterplatte eingebracht werden.

Die Plättchen aus isoliertem Metallsubstrat können mit optimaler Panel-Ausnützung direkt vom Rohmaterialhersteller als Stanzware, die aus Platten aus isoliertem Metallsubstrat gefertigt werden, kostengünstig bezogen werden. Der Aufwand für die Herstellung der Leiterplatte (Boardhouse-Aufwand) kann reduziert werden.

Das erfindungsgemäße Plättchen kann eine Isolationsschicht aufweisen, die zwischen zwei Metallschichten eingebettet ist, wobei eine erste Metallschicht die Leiterplatte kontaktiert und die zweite Metallschicht das Kühlelement. Durch die Isolationsschicht ist die Leiterplatte galvanisch vom Kühlelement getrennt, durch die Metallschichten ist eine gute Wärmeleitung gegeben. Die Schichten des Plättchens verlaufen in der Regel parallel zu den Schichten der Leiterplatte.

Dabei kann die erste Metallschicht des Plättchens dünner sein als die zweite Metallschicht. Dies liegt an der Herstellungsart des isolierten Metallsubstrats. Dabei wird auf eine metallische Grundplatte, etwa aus Kupfer oder Aluminium, eine dünne dielektrische Schicht (etwa 30-100 Mikrometer dick) aufgebracht und darauf wieder eine Metallschicht (etwa 35-200 Mikrometer dick). Das Dielektrikum wird wegen der - im Vergleich zu Metall - schlechten Wärmeleitung möglichst dünn ausgeführt. Das Anliegen der ersten (dünneren) Metallschicht an der Leiterplatte und der zweiten (dickeren) Metallschicht am Kühlelement hat den Vorteil, dass das metallische Material der zweiten Metallschicht und das des Kühlelements das gleiche sein können, z.B. Aluminium, und daher keine Korrosionsprobleme zu erwarten sind.

Das Kühlelement kann eine Freistellung für das Plättchen aufweisen und seitlich neben dem Plättchen an der Außenfläche der Außenschicht der Leiterplatte anliegen. Auf diese Weise kann die vom Plättchen aufgenommene Wärme gut an das Kühlelement, etwa einen Kühlkörper, abgegeben werden, weil das Plättchen - bis auf seine Kontaktfläche mit der Leiterplatte - ganz vom Kühlkörper umgeben ist.

Besonders günstig ist, wenn das Kühlelement eine Freistellung für das Plättchen aufweist, die so bemessen ist, dass das Plättchen durch das Kühlelement sowohl in Kontakt mit den metallischen Durchkontaktierungen als auch mit dem Kühlelement gehalten wird. Denn dann muss das Plättchen nicht eigens an der Leiterplatte befestigt werden, sondern wird einfach vom Kühlkörper an seinem Platz gehalten.

Plättchen und Kühlelement können mittels Kerb- oder Pressverbindung miteinander verbunden sein, um ein seitliches (= parallel zur Ebene der Leiterplatte im montierten Zustand des Kühlelements bzw. Plättchens) Verrutschen des Plättchens in der Freistellung des Kühlelements zu verhindern.

Sobald die Leiterplatte bestückt ist, ist auf der Kontaktfläche für ein zu kühlendes Bauelement ein zu kühlendes Bauelement angeordnet, wie etwa ein Leistungstransistor (z.B. ein MOSFET) oder eine Leuchtdiode (z.B. eine Power LED).

Ein Verfahren zur Herstellung einer - insbesondere erfindungsgemäßen - Leiterplatte sieht vor,
- dass in einer Leiterplatte mit zwei metallischen Außenschichten und mindestens einer, insbesondere metallischen, Zwischenschicht, wobei im Falle der metallischen Zwischenschicht zwischen den Außenschichten und der Zwischenschicht Isolierschichten angeordnet sind, eine oder mehrere metallische Durchkontaktierungen erzeugt werden, die eine Kontaktfläche für ein zu kühlendes Bauelement auf einer Außenfläche der Leiterplatte mit der gegenüber liegenden Außenfläche der Leiterplatte verbinden, und
- dass auf der gegenüber liegenden Außenfläche der Leiterplatte ein Plättchen aus isoliertem Metallsubstrat außen an der Außenfläche der Leiterplatte an den Durchkontaktierungen angebracht wird und das Plättchen mit einem Kühlelement, das ebenfalls an dieser Außenfläche angebracht wird, in Kontakt gebracht wird.

Bevorzugt weist das Kühlelement eine Freistellung für das Plättchen auf, in welche das Plättchen eingelegt wird und durch Montage des Kühlelements an der Leiterplatte das eingelegte Plättchen dauerhaft einerseits mit den metallischen Durchkontaktierungen und andererseits mit dem Kühlelement in Kontakt gebracht wird. Das Einlegen des Plättchens kann vom Hersteller des Kühlelements, das meist einfach ein Kühlkörper ist, erfolgen. Die Leiterplatte kann dann wie gewohnt im Elektronikwerk montiert werden, wobei das Kühlelement mit dem Plättchen erst nach der Montage der anderen Bauteile und nach Überprüfung der Schaltkreise montiert wird.

Mit einer erfindungsgemäßen Leiterplatte können logische Bereiche und Leistungsbereiche einer elektronischen Schaltung auf einer Leiterplatte untergebracht werden, es entfällt die Anordnung auf zwei getrennten Leiterplatten mit Steckverbindung.

### Kurzbeschreibung der Figuren

Zur weiteren Erläuterung der Erfindung wird im nachfolgenden Teil der Beschreibung auf die Figuren Bezug genommen, aus denen weitere vorteilhafte Ausgestaltungen, Einzelheiten und Weiterbildungen der Erfindung zu entnehmen sind. Es zeigen
- Fig. 1: eine schematische Darstellung einer Leiterplatte gemäß dem Stand der Technik im Querschnitt,
- Fig. 2: eine schematische Darstellung einer erfindungsgemäßen Leiterplatte im Querschnitt

### Ausführung der Erfindung

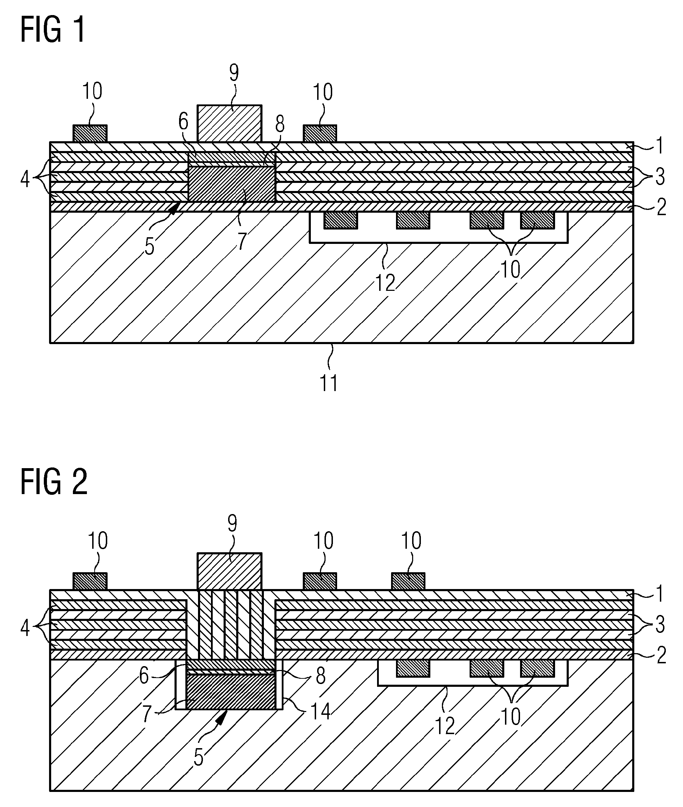

In Fig. 1 ist eine Leiterplatte dargestellt, die zwei metallische Außenschichten 1, 2, zwei metallische Zwischenschichten 3 und zwischen den metallischen Schichten 1-3 jeweils eine Isolierschicht 4 aufweist. Die metallischen Schichten 1-3 bestehen hier aus Kupfer und sind hier gleich dick dargestellt. Die Dicke der metallischen Außenschichten 1, 2 liegt typischer Weise zwischen 18 und 105 Mikrometern, die Dicke der metallischen Zwischenschichten 3 liegt typischer Weise zwischen 18 und 50 Mikrometern. Die Isolierschichten 4 haben hier eine Dicke von etwa 50 Mikrometern und enthalten sogenannte vorimprägnierte Fasern, die auch als Prepreg bezeichnet werden, Prepreg ist die englische Kurzform für preimpregnated fibres. Vorimprägnierte Fasern sind mit Reaktionsharzen vorimprägnierte textile Halbzeuge, die zur Herstellung von Leiterplatten unter Temperatur und Druck ausgehärtet werden. Insbesondere können die Isolierschichten 4 der Klasse FR-4 angehören, einer Klasse von schwer entflammbaren und flammenhemmenden Verbundwerkstoffen bestehend aus Epoxidharz und Glasfasergewebe.

Innerhalb der Leiterplatte, genauer in den Schichten 3, 4, ist nun ein Plättchen 5 aus isoliertem Metallsubstrat vorgesehen, das hier in der Ebene der Leiterplatte eine quadratische Grundfläche aufweist. Das Plättchen 5 ist dreischichtig aufgebaut, mit einer ersten Metallschicht 6, welche die erste metallische Außenschicht 1 der Leiterplatte von innen kontaktiert, mit einer zweiten Metallschicht 7, welche die zweite metallische Außenschicht 2 der Leiterplatte von innen kontaktiert sowie mit einer Isolationsschicht 8, welche die beiden Metallschichten 6,7 galvanisch voneinander trennt.

Bei der Herstellung der Leiterplatten werden zuerst die metallischen Zwischenschichten 3 und die dazwischen befindliche Isolierschicht 4 miteinander verbunden, dann wird pro Plättchen eine Ausnehmung in die Schichten 3, 4 gefräst, welche Ausnehmung den Außenabmessungen des Plättchens 5 zu entsprechen hat. Anschließend wird das Plättchen 5 in die Ausnehmung eingesetzt und es werden die äußeren Isolierschichten 4 und dann die metallischen Außenschichten 1, 2 auf die Zwischenschichten 3 aufgebracht, sodass die Innenflächen der metallischen Außenschichten 1, 2 mit dem Plättchen 5 in Kontakt kommen, genauer mit den Außenflächen der Metallschichten 6, 7.

Plättchen 5 ist - in der Ebene der Leiterplatte gesehen - breiter als der zu kühlende Bauteil 9, der an der Außenfläche der Leiterplatte, genauer der ersten metallischen Außenschicht 1, über eine Kontaktfläche befestigt ist.

Die Wärme, die der Bauteil 9 erzeugt, wird über die Außenschicht 1, das Plättchen 5 und die Außenschicht 2 auf die dem Bauteil 9 gegenüber liegende Seite der Leiterplatte geleitet, wo ein Kühlelement 11, hier ein metallischer Kühlkörper, etwa aus Aluminium, flächig in Kontakt mit der Außenfläche der Außenschicht 2 steht. Auf der Leiterplatte sind auf einer oder auf beiden Außenschichten 1,2 weitere Standardbauteile 10 angeordnet. Einige Standardbauteile 10 sind in einer Freistellung 12 des Kühlkörpers 11 angeordnet.

In Fig. 2 ist eine erfindungsgemäße Leiterplatte dargestellt. Der Aufbau der einzelnen Schichten 1-4 der Leiterplatte ist gleich wie in Fig. 1, ebenso der Aufbau des Plättchens mit seinen Schichten 6-8. Auch hier ist die Grundfläche des Plättchens 5 quadratisch, sie könnte natürlich auch rechteckig sein oder eine andere Form aufweisen, die den Umrissen des zu kühlenden Bauteils 9 entspricht. Allerdings ist das Plättchen 5 hier nicht in der Leiterplatte, sondern außerhalb der Leiterplatte angeordnet, und zwar dem zu kühlenden Bauteil 9 gegenüberliegend auf der anderen Seite der Leiterplatte, auf der Außenfläche der zweiten Außenschicht 2. Damit dennoch die Wärme vom Bauteil 9 zum Plättchen 5 geleitet werden kann, sind in einem Bereich der Leiterplatte, der etwas breiter ist als der Bauteil 9 (bzw. die entsprechende Kontaktfläche für den Bauteil 9), in regelmäßigen Abständen Durchkontaktierungen 13 vorgesehen, die hier gerade und normal zur Ebene der Leiterplatte verlaufen und die beiden Außenflächen der Leiterplatte thermisch und galvanisch leitend miteinander verbinden. Die Durchkontaktierungen 13 müssen dabei zumindest den Bereich unterhalb des Bauteils 9 abdecken.

Während auf einer Seite der Leiterplatte der zu kühlende Bauteil 9 mit den Durchkontaktierungen 13 verbunden ist, ist auf der anderen Seite der Leiterplatte das Plättchen 5 mit seiner ersten (dünnen) Metallschicht 6 mit den Durchkontaktierungen 13 verbunden. Die zweite (dicke) Metallschicht 7 des Plättchens 5 ist in thermischem und galvanischem Kontakt mit der Innenseite einer Freistellung 14 für das Plättchen 5 im Kühlkörper 11. Normal zur Leiterplatte entspricht die Abmessung der Freistellung 14 der Dicke des Plättchens 5, sodass das Plättchen 5 nicht eigens an der Leiterplatte befestigt werden muss, sondern lediglich durch den Kühlkörper 11 gegen die Leiterplatte gedrückt wird, der ohnehin an der Leiterplatte befestigt werden muss. Seitlich, also links und rechts in Fig. 2, ist das Plättchen 5 vom Kühlkörper 11, also den Wänden der Freistellung 14, beabstandet, damit es zu keinem Kurzschluss zwischen erster Metallschicht 6 und Kühlkörper 11 kommt.

Der gleiche Kühlkörper 11 kann auch wie in Fig. 1 eine Freistellung für weitere Bauteile, wie Standardbauteile 10, aufweisen. Abgesehen von den Freistellungen 12, 14 liegt der Kühlkörper 11 flächig an der zweiten metallischen Außenschicht 2 auf. Der Kühlkörper 11 wird in der Regel aus Aluminium gefertigt sein.

In Fig. 1 sollten beide Metallschichten 6, 7 des Plättchens 5 aus dem gleichen Material wie die metallischen Außenschichten 1, 2 der Leiterplatte bestehen, damit keine ungünstigen Spannungsreihen entstehen, da das Plättchen 5 ja an den Außenschichten 1, 2 anliegt. In Fig. 1 sollten die Metallschichten 6, 7 daher aus Kupfer sein. In Fig. 2 kann zumindest die zweite, dickere Metallschicht 7, die am Kühlkörper 11 anliegt, aus einem anderen Material als die Außenschicht 2 der Leiterplatte bestehen, z.B. aus Aluminium. Dies hat den Vorteil, dass das Plättchen 5 im Vergleich zur Ausführung in Fig. 1 leichter wird.

Bei der Wahl der Materialien der Metallschichten 6, 7 des Plättchens 5 ist auch auf etwaige metallische Beschichtungen der Leiterplatte bzw. der metallischen Außenschichten 1, 2 Bedacht zu nehmen, damit es nicht zu ungewollten Potentialunterschieden kommt.

Plättchen 5 und Kühlkörper 11 können mittels Kerb- oder Pressverbindung miteinander verbunden sein, damit die Lage des Plättchens 5 innerhalb der Freistellung 14 parallel zur Ebene der Leiterplatte festgelegt ist. Dies stellt sicher, dass bei der Montage des Kühlkörpers 11 an der Leiterplatte das Plättchen 5 relativ zu den Durchkontaktierungen 13 richtig positioniert ist. Sobald der Kühlkörper 11 montiert ist, kann das Plättchen durch die vom Kühlkörper 11 ausgeübte Kraft ohnehin nicht mehr verrutschen.

Die erste 6 und zweite Metallschicht 7 des Plättchens 5 kann aus Kupfer oder Aluminium bestehen. Die erste Metallschicht 6 hat typischer Weise eine Dicke von 50 Mikrometern, die zweite Metallschicht 7 von 1000-1500 Mikrometern. Die Isolationsschicht 8, welche die beiden Metallschichten 6,7 galvanisch voneinander trennt, hat typischer Weise nur eine Dicke von 30-50 Mikrometern, wenn entsprechende verfügbare Dielektrika mit hoher Wärmebeständigkeit verwendet werden. So sind etwa Dielektrika verfügbar, die bei einer Dicke von 38 Mikrometern eine Glasübergangstemperatur von 185°C aufweisen bei einer spezifische Wärmeleitfähigkeit von 7-10 W/m*K.

Die Gesamtdicke des Plättchens 5 liegt somit typischer Weise bei 1000-1500 Mikrometern.

### Bezugszeichenliste:

- 1: erste (obere) metallische Außenschicht
- 2: zweite (untere) metallische Außenschicht
- 3: metallische Zwischenschicht
- 4: Isolierschicht
- 5: Plättchen aus isoliertem Metallsubstrat
- 6: erste Metallschicht des Plättchens 5
- 7: zweite Metallschicht des Plättchens 5
- 8: Isolationsschicht des Plättchens 5
- 9: zu kühlender Bauteil
- 10: Standardbauteile
- 11: Kühlelement (Kühlkörper)
- 12: Freistellung für Standardbauteile 10
- 13: Durchkontaktierungen
- 14: Freistellung für Plättchen 5

## Patentansprüche

1. Leiterplatte mit zwei metallischen Außenschichten (1, 2) und mindestens einer, insbesondere metallischen, Zwischenschicht (3),
- wobei im Falle einer metallischen Zwischenschicht zwischen den Außenschichten (1, 2) und der Zwischenschicht (3) Isolierschichten (4) angeordnet sind,
- wobei auf mindestens einer der Außenflächen der Leiterplatte mindestens eine Kontaktfläche für ein zu kühlendes Bauelement (9) angeordnet ist,
- wobei auf der gegenüber liegenden Außenfläche der Leiterplatte mindestens ein Kühlelement (11) angeordnet ist, und
- wobei die Kontaktfläche für das zu kühlende Bauelement (9) mittels eines Plättchens (5) aus isoliertem Metallsubstrat elektrisch vom Kühlelement (11) isoliert ist, **dadurch gekennzeichnet, dass** die Kontaktfläche für das zu kühlende Bauelement (9) durch eine oder mehrere metallische Durchkontaktierungen (13) mit der gegenüber liegenden Außenfläche der Leiterplatte verbunden ist, wo das Plättchen (5) aus isoliertem Metallsubstrat außen an der Außenfläche der Leiterplatte angebracht und mit dem Kühlelement (11) in Kontakt ist.

2. Leiterplatte nach Anspruch 1, **dadurch gekennzeichnet, dass** das Plättchen (5) eine Isolationsschicht (8) aufweist, die zwischen zwei Metallschichten (6, 7) eingebettet ist, wobei eine erste Metallschicht (6) die Leiterplatte kontaktiert und die zweite Metallschicht (7) das Kühlelement.

3. Leiterplatte nach Anspruch 2, **dadurch gekennzeichnet, dass** die erste Metallschicht (6) dünner ist als die zweite Metallschicht (7).

4. Leiterplatte einem der Ansprüche 1 bis 3, **dadurch gekennzeichnet, dass** das Kühlelement (11) eine Freistellung (14) für das Plättchen (5) aufweist und seitlich neben dem Plättchen (5) an der Außenfläche der Außenschicht der Leiterplatte anliegt.

5. Leiterplatte nach einem der Ansprüche 1 bis 4, **dadurch gekennzeichnet, dass** das Kühlelement (11) eine Freistellung (14) für das Plättchen (5) aufweist, die so bemessen ist, dass das Plättchen (5) durch das Kühlelement (11) sowohl in Kontakt mit den metallischen Durchkontaktierungen (13) als auch mit dem Kühlelement (11) gehalten wird.

6. Leiterplatte nach einem der Ansprüche 4 oder 5, **dadurch gekennzeichnet, dass** Plättchen (5) und Kühlelement (11) mittels Kerb- oder Pressverbindung miteinander verbunden sind.

7. Verfahren zur Herstellung einer Leiterplatte, **dadurch gekennzeichnet,**
- **dass** in einer Leiterplatte mit zwei metallischen Außenschichten (1, 2) und mindestens einer, insbesondere metallischen, Zwischenschicht (3), wobei im Falle der metallischen Zwischenschicht zwischen den Außenschichten (1, 2) und der Zwischenschicht (3) Isolierschichten (4) angeordnet sind, eine oder mehrere metallische Durchkontaktierungen (13) erzeugt werden, die eine Kontaktfläche für ein zu kühlendes Bauelement (9) auf einer Außenfläche der Leiterplatte mit der gegenüber liegenden Außenfläche der Leiterplatte verbinden, und
- **dass** auf der gegenüber liegenden Außenfläche der Leiterplatte ein Plättchen (5) aus isoliertem Metallsubstrat außen an der Außenfläche der Leiterplatte an den Durchkontaktierungen (13) angebracht wird und das Plättchen (5) mit einem Kühlelement (11), das ebenfalls an dieser Außenfläche angebracht wird, in Kontakt gebracht wird.

8. Verfahren nach Anspruch 7, **dadurch gekennzeichnet, dass** das Kühlelement (11) eine Freistellung (14) für das Plättchen (5) aufweist, in welche das Plättchen eingelegt wird und durch Montage des Kühlelements (11) an der Leiterplatte das eingelegte Plättchen (5) dauerhaft einerseits mit den metallischen Durchkontaktierungen (13) und andererseits mit dem Kühlelement (11) in Kontakt gebracht wird.
